# FASCICULE DE BREVET EUROPEEN

(11) **EP 3 246 948 B1**
(45) Date de publication et mention de la délivrance du brevet: **18.11.2020**
(21) Numéro de dépôt: 17171978.4
(22) Date de dépôt: 19.05.2017
(51) Int. Cl.: H01L 27/12, H01L 29/66, H01L 21/84

(54) **PROCÉDÉ DE RÉALISATION SUR UN MÊME SUBSTRAT DE TRANSISTORS PRÉSENTANT DES CARACTÉRISTIQUES DIFFÉRENTES**
VERFAHREN ZUR HERSTELLUNG VON TRANSISTOREN, DIE UNTERSCHIEDLICHE EIGENSCHAFTEN AUFWEISEN, AUF DEMSELBEN SUBSTRAT
METHOD FOR FORMING, ON A SINGLE SUBSTRATE, TRANSISTORS HAVING DIFFERENT CHARACTERISTICS

(30) Priorité: 20.05.2016 FR 1654554
(43) Date de publication de la demande: 22.11.2017
(73) Titulaire: Commissariat à l'Energie Atomique et aux Energies Alternatives, 75015 Paris (FR)
(72) Inventeur: GRENOUILLET, Laurent, 38640 Claix (FR); BARNOLA, Sébastien, 38190 Villard-Bonnot (FR); JAUD, Marie-Anne, 38640 Claix (FR); MAZURIER, Jérôme, 33610 Cestas (FR); POSSEME, Nicolas, 38360 Sassenage (FR)
(74) Mandataire: Hautier, Nicolas

(56) Documents cités:
- WO-A1-2012/046365
- WO-A1-2014/162164
- US-A1- 2006 205 134
- US-A1- 2015 035 072

## Description

### DOMAINE TECHNIQUE DE L'INVENTION

La présente invention concerne la réalisation sur un même substrat de transistors présentant des caractéristiques différentes, par exemple des oxydes de grille dont les épaisseurs sont différentes. Elle trouvera pour application avantageuse la réalisation de tels transistors sur un substrat de type FDSOI.

### ÉTAT DE LA TECHNIQUE

Le document WO 2012/046335 décrit un procédé pour réaliser sur un substrat massif des transistors présentant des caractéristiques différentes.

Pour certains circuits, il est nécessaire de réaliser sur un même substrat élaboré, également désigné tranche ou wafer en anglais, des transistors présentant des caractéristiques différentes, par exemple des épaisseurs différentes d'oxyde de grille.

Les substrats élaborés comprennent généralement un substrat de support surmonté d'une couche d'oxyde et d'une couche semi-conductrice dont l'épaisseur est fine. Ils sont qualifiés de FDSOI (fully depleted silicon on insulator signifiant silicium-sur-isolant totalement déserté ou plus généralement semiconducteur-sur-isolant totalement déserté) ou PDSOI (partially depleted silicon on insulator signifiant silicium-sur-isolant partiellement déserté ou plus généralement semiconducteur-sur-isolant partiellement déserté) en fonction principalement de l'épaisseur de la couche semi-conductrice.

Les transistors que l'on réalise sur ce type de substrats élaborés présentent un empilement de grille comprenant notamment une grille habituellement en silicium dopé ou en métal, une couche métallique et une couche isolante électriquement dite d'oxyde de grille située entre la couche active et la grille en silicium polycristallin.

Sur un même substrat élaboré, on peut réaliser des transistors d'un premier type présentant une caractéristique différente de celle d'un deuxième type de transistor. Par exemple on peut réaliser, sur un même substrat, des transistors d'un premier type présentant une première épaisseur d'oxyde de grille et des transistors d'un second type présentant une deuxième épaisseur d'oxyde de grille supérieure à la première épaisseur afin de fonctionner à des tensions supérieures.

Afin de limiter la complexité du procédé, de nombreuses étapes sont communes à la réalisation des deux types de transistors dont notamment la réalisation de la couche métallique, la grille en polysilicium, les espaceurs, les sources et drains.

La présente invention a pour objectif de proposer une solution pour intégrer de manière reproductible et simple, sur un même substrat, des transistors présentant des caractéristiques différentes, par exemple des oxydes de grille dont les épaisseurs sont différentes.

### RÉSUMÉ DE L'INVENTION

Pour atteindre cet objectif, selon un mode de réalisation la présente invention prévoit un procédé de réalisation sur un même substrat de préférence de type semi-conducteur sur isolant d'au moins un premier transistor et d'au moins un deuxième transistor, le procédé comprenant au moins les étapes suivantes :
- Réalisation sur un substrat de type semi-conducteur sur isolant d'au moins un premier motif de grille et d'au moins un deuxième motif de grille;
- Dépôt sur le premier et le deuxième motif de grille d'au moins :
   - une première couche de protection,
   - une deuxième couche de protection surmontant la première couche de protection et faite en un matériau différent de celui de la première couche de protection et;
- Masquage du deuxième motif par une couche de masquage;
- Gravure isotrope de la deuxième couche de protection située sur le premier motif, en conservant la première couche de protection sur le premier motif, le deuxième motif étant masqué par la couche de masquage lors de cette gravure isotrope;
- Retrait de la couche de masquage après l'étape de gravure isotrope ;
- Avant l'étape de masquage ou après l'étape de retrait de la couche de masquage: gravure anisotrope de la deuxième couche de protection sélectivement à la première couche de protection, de manière à retirer au moins en partie, de préférence toute, la deuxième couche de protection située sur un sommet du deuxième motif de grille et à conserver au moins une partie de, de préférence toute, l'épaisseur de la deuxième couche de protection située sur des flancs du deuxième motif de grille,
- avant l'étape de dépôt de la première et de la deuxième couche de protection, une étape de dépôt sur les premier et deuxième motifs de grille de la troisième couche de protection disposée sous la première couche de protection et recouvrant les premier et deuxième motifs de grille,
- après la gravure anisotrope de la deuxième couche de protection sélectivement à la première couche de protection: une étape de gravure de la première couche de protection sélectivement à la troisième couche de protection de manière à retirer entièrement sur le premier motif de grille la première couche de protection et à conserver la troisième couche de protection.

Ainsi, le procédé selon l'invention permet de réaliser sur les flancs du deuxième motif des espaceurs d'épaisseur plus importante que sur les flancs du premier motif.

La présente invention propose ainsi une solution pour intégrer de manière reproductible et simple, sur un même substrat, des transistors présentant des caractéristiques différentes.

Elle offre un avantage particulièrement intéressant pour la réalisation sur un même substrat de transistors dont les empilements de grille présentent des couches isolantes, typiquement des oxydes de grille, dont les épaisseurs sont différentes. En pratique, il a été constaté qu'avec les solutions connues, bien souvent les performances des transistors dont les oxydes de grille sont plus épais se dégradent au fur et à mesure de leur utilisation.

Par conséquent, avec les solutions connues, les performances et la durée de vie des dispositifs comportant ces transistors peuvent représenter une barrière à leur industrialisation.

Dans le cadre de développement de la présente invention, il a été remarqué qu'avec les solutions connues, dans le transistor présentant un empilement de grille dont l'oxyde de grille le plus épais, le champ électrique est le plus élevé à l'interface entre source/drain et espaceurs et non pas au niveau de l'oxyde de grille, comme cela était prévisible.

Ce fort champ électrique peut entraîner le claquage de l'espaceur au fur et à mesure du fonctionnement du transistor.

En prévoyant un espaceur plus épais sur les flancs de la grille du deuxième transistor qui doit supporter des tensions plus élevées, l'invention permet de supprimer ce risque de claquage.

Par ailleurs, l'invention permet de conserver sur les flancs de la grille du premier transistor une épaisseur fine d'espaceur. L'invention permet ainsi de conserver les performances des transistors dont les oxydes de grille sont les plus fins.

Le procédé selon l'invention permet également de s'intégrer parfaitement dans les procédés standards dans lesquels les flancs du premier motif de grille sont recouverts par un espaceurs monocouche.

En outre, l'invention présente une complexité limitée par rapport aux solutions classiques dans lesquelles les espaceurs de grille sur les flancs des premier et deuxième transistors sont d'épaisseurs identiques. Notamment le procédé selon l'invention ne nécessite pas de masque additionnel de lithographie. En particulier, de manière avantageuse, le niveau de masque permettant d'introduire la différence d'épaisseur sur l'espaceur est le même que celui utilisé pour induire la différence d'oxyde de grille.

En outre ce procédé ne requiert pas de surgravure additionnelle qui pourrait détériorer la couche active. Ainsi, l'invention s'avère particulièrement avantageuse lorsque le canal présent une épaisseur fine, ce qui est le cas lorsque les empilements sont formés sur un substrat de type SOI ou FDSOI.

Le procédé selon l'invention est ainsi compatible avec les étapes subséquentes qui sont conventionnelles pour finaliser la réalisation des transistors.

Ainsi, l'invention offre une solution efficace, aisément industrialisable et peu onéreuse pour améliorer les performances et la durée de vie des dispositifs présentant des caractéristiques différentes, par exemple des transistors dont les oxydes de grille ont des épaisseurs différentes.

Elle est particulièrement avantageuse pour la réalisation de transistors FDSOI. L'invention s'applique néanmoins notamment aux transistors formés sur des substrats massifs (en anglais « bulk ») ou sur des substrats de type PDSOI.

De manière facultative, l'invention peut en outre présenter au moins l'une quelconque des caractéristiques optionnelles suivantes :
- Selon un mode de réalisation, le premier motif de grille est un premier empilement de grille, et le deuxième motif de grille est un deuxième empilement de grille.

Selon un autre mode de réalisation, le premier motif de grille est un motif sacrificiel et le deuxième motif est un motif sacrificiel. Le procédé comprend, après ladite étape de gravure sélective des portions modifiées, une étape de remplacement des premiers et deuxième motifs sacrificiels par des motifs formant respectivement un premier empilement de grille et un deuxième empilement de grille.
- Selon un autre mode de réalisation, chacun des premier et deuxième empilements de grille comprend au moins une couche isolante, typiquement un oxyde de grille, l'épaisseur de la couche isolante du deuxième empilement étant supérieure à l'épaisseur de la couche isolante du premier empilement.
- Selon un mode de réalisation, l'épaisseur de l'oxyde de grille du premier empilement est comprise entre 0 et 3 nm (10⁻⁹ mètres) et de préférence entre 0 et 1,5 nm.
- Selon un mode de réalisation, l'épaisseur de l'oxyde de grille du deuxième empilement est comprise entre 1,5 et 8 nm, de préférence entre 2 et 6 nm et de préférence entre 2 et 3,5 nm.
- Selon un mode de réalisation le motif de grille est destiné à former une grille pour le transistor. Le motif de grille est alors fonctionnel. Il s'agit alors d'un procédé que l'on peut qualifier de « gate first », c'est-à-dire dans lequel la grille est réalisée au préalable. Selon un autre mode de réalisation, le motif de grille est destiné à être retiré, après avoir formé les espaceurs, pour ensuite être remplacé par un motif fonctionnel de grille. Le motif de grille est alors sacrificiel. Il s'agit alors d'un procédé que l'on peut qualifier de « gate last», c'est-à-dire dans lequel la grille est réalisée dans un second temps.
- Selon un mode de réalisation, la troisième couche de protection est en nitrure, de préférence en nitrure de silicium ou en un matériau présentant une constante diélectrique inférieure à 7. La troisième couche de protection est en un matériau identique à celui de la deuxième couche de protection.
- Selon un mode de réalisation, le procédé comprend, après l'étape de gravure anisotrope de la deuxième couche de protection, une étape de retrait de la première couche de protection située sur le sommet du deuxième motif, sur le premier motif et entre les premier et deuxième motif, par gravure sélective du matériau de la première couche de protection vis-à-vis du matériau de la deuxième couche de protection et du matériau de la troisième couche de protection.
- Selon un mode de réalisation, le procédé comprend, après l'étape de retrait de la première couche sur le premier motif, une étape de dépôt d'une couche d'encapsulation en un matériau présentant une constante diélectrique inférieure ou égale à 8 sur au moins le deuxième motif.
Cette étape permet de combler une ouverture dans la deuxième couche de protection du deuxième motif et par laquelle la première couche de protection présente sur les flancs du deuxième motif est rendue accessible lors de l'étape de retrait de la première couche de protection sur le sommet du deuxième motif. Cette étape permet ainsi d'encapsuler et donc de protéger l'espaceur formé par la première couche sur le deuxième motif. Ainsi, lors d'une gravure ou d'un nettoyage ultérieur, par exemple à base d'HF, l'espaceur formé par la première couche de protection sur les flancs du deuxième motif n'est pas dégradé.
- Selon un mode de réalisation, le substrat est de type semi-conducteur sur isolant. Alternativement, il peut s'agir d'un substrat massif, habituellement désigné « bulk ».
- Selon un mode de réalisation, la deuxième couche de protection est en nitrure, de préférence en nitrure de silicium (SiN) et la première couche de protection est un oxyde, de préférence de l'oxyde de silicium (SiO2).
- Selon un mode de réalisation, l'étape de gravure isotrope de la deuxième couche de protection est une gravure humide, de préférence à base d'une solution de H3PO4 chaud.
- Selon un mode de réalisation, l'étape de gravure isotrope de la deuxième couche de protection est une gravure sèche, utilisant de préférence une chimie fluorocarbonée ou fluorée.
- Selon un mode de réalisation, la gravure sèche est effectuée dans un réacteur plasma dans lequel une tension de polarisation bias et/ou la tension de la source est puisée. Cela permet d'améliorer isotropie de la gravure.
- Selon un mode de réalisation, le retrait de la couche de masquage est effectué par gravure de la couche de masquage relativement à la première couche de protection.
- Selon un mode de réalisation, la gravure de la couche de masquage est une gravure sèche à base d'une chimie réductrice ou oxydante.
- Selon un mode de réalisation, la couche de masquage est une résine. Le retrait de la couche de masquage comprend une gravure sèche, de préférence à base d'un mélange de N2/H2, puis d'un nettoyage humide, de préférence à base de SC1 (NH₄OH-H₂O₂).
- Selon un mode de réalisation, la gravure anisotrope de la deuxième couche de protection sélectivement à la première couche de protection est effectuée après l'étape de retrait de la couche de masquage.
Commencer par la gravure isotrope puis ensuite effectuer la gravure anisotrope offre pour avantage de permettre de relâcher la contrainte sur la consommation de couches comme le SiO2 qui ne doivent pas être consommées lors de la gravure des couches de protection.
- Alternativement, la gravure anisotrope de la deuxième couche de protection sélectivement à la première couche de protection est effectuée avant ladite étape de masquage.
- Selon un mode de réalisation particulièrement avantageux, au moins l'une parmi la première, la deuxième et la troisième couche protections est réalisée par un dépôt conforme. De préférence, chacune des première, deuxième et troisième couche protections est réalisée par un dépôt conforme.
- Selon un mode de réalisation, la deuxième couche de protection est un nitrure ou un matériau présentant une constante diélectrique inférieure à 7 et ladite étape de gravure anisotrope de la deuxième couche de protection comprend :
   - une étape de protection par formation d'un film protecteur d'oxyde sur les premier et deuxième motifs ;
   - la gravure anisotrope du film protecteur d'oxyde en dehors des flancs des premier et deuxième motifs de manière à conserver le film protecteur d'oxyde uniquement sur les flancs des premier et deuxième motifs ;
   - la gravure d'une partie au moins de la deuxième couche de protection située sur un sommet et de part et d'autre du deuxième motif, la gravure étant sélective vis-à-vis du film protecteur d'oxyde situé sur les flancs des premier et deuxième motifs et de la première couche de protection située sur le sommet du premier motif.

La formation du film protecteur d'oxyde permet de protéger efficacement la deuxième couche de protection présente sur les flancs du deuxième motif lors de la gravure de la deuxième couche sur le sommet du deuxième motif.

Par ailleurs, cette étape permet de conserver une partie au moins de la première couche de protection sur le premier motif.

Par ailleurs, de manière également facultative, l'invention peut en outre présenter au moins l'une quelconque des caractéristiques optionnelles suivantes :
- Selon un mode de réalisation, le procédé comprend une étape de surgravure pour retirer entièrement la deuxième couche de protection sur le sommet du deuxième motif, ladite surgravure étant sélective de la deuxième couche de protection vis-à-vis de la première couche de protection.
- Selon un mode de réalisation, ladite surgravure est une gravure anisotrope ayant une direction principale de gravure perpendiculaire audit substrat.
- Selon un mode de réalisation, la deuxième couche de protection est en nitrure, de préférence en nitrure de silicium (SiN) ou en un matériau dont la constante diélectrique est inférieure à 7, la première couche de protection est un oxyde, de préférence un oxyde de silicium (SiO2) et le film protecteur d'oxyde est formé à partir d'un plasma à base d'oxygène.
- Selon un mode de réalisation, le procédé comprend, après l'étape de gravure anisotrope de la deuxième couche de protection, une étape de retrait de la première couche de protection située sur le sommet du deuxième motif, sur le premier motif et entre les premier et deuxième motif, par gravure sélective du matériau de la première couche de protection vis-à-vis du matériau de la deuxième couche de protection.
Selon un mode de réalisation, le procédé comprend ensuite une étape de dépôt d'une troisième couche de protection recouvrant les premier et deuxième motifs.

L'invention sera particulièrement avantageuse pour réaliser un dispositif microélectronique comprenant sur un même substrat de type semi-conducteur sur isolant au moins un premier transistor et au moins un deuxième transistor présentant chacun un motif de grille et des espaceurs situés sur des flancs des motifs, chaque motif de grille comprend un empilement de grille comprenant au moins une grille et une couche isolante située entre la grille et une couche active dudit substrat. La couche isolante de grille du deuxième transistor présente une épaisseur supérieure à celle du motif du premier transistor. Les espaceurs du deuxième transistor sont plus épais que les espaceurs du premier transistor.

Par dispositif microélectronique, on entend tout type de dispositif réalisé avec des moyens de la microélectronique. Ces dispositifs englobent notamment en plus des dispositifs à finalité purement électronique, des dispositifs micromécaniques ou électromécaniques (MEMS, NEMS...) ainsi que des dispositifs optiques ou optoélectroniques (MOEMS...).

De manière facultative, le substrat est de type SOI et de préférence de type FDSOI.

Les autres objets, caractéristiques et avantages de la présente invention apparaîtront à l'examen de la description suivante et des dessins d'accompagnement. Il est entendu que d'autres avantages peuvent être incorporés.

### BRÈVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :
La FIGURE 1 est une représentation schématique d'un substrat élaboré comprenant deux motifs de grille dont les oxydes de grille ont des épaisseurs différentes.
Les FIGURES 2 à 12 illustrent des étapes d'un mode de réalisation du procédé selon l'invention.
La FIGURE 13 illustre une étape d'un mode de réalisation alternatif.
La FIGURE 14 résume certaines étapes de deux exemples de procédé selon l'invention.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier les épaisseurs relatives des différentes couches et films ne sont pas représentatives de la réalité.

### DESCRIPTION DÉTAILLÉE DE L'INVENTION

Il est précisé que dans le cadre de la présente invention, le terme « sur », « surmonte », « recouvre » ou « sous-jacent » ou leurs équivalents ne signifient pas forcément « au contact de ». Ainsi par exemple, le dépôt d'une première couche sur une deuxième couche, ne signifie pas obligatoirement que les deux couches sont directement au contact l'une de l'autre mais cela signifie que la première couche recouvre au moins partiellement la deuxième couche en étant soit directement à son contact soit en étant séparée d'elle par au moins une autre couche ou au moins un autre élément.

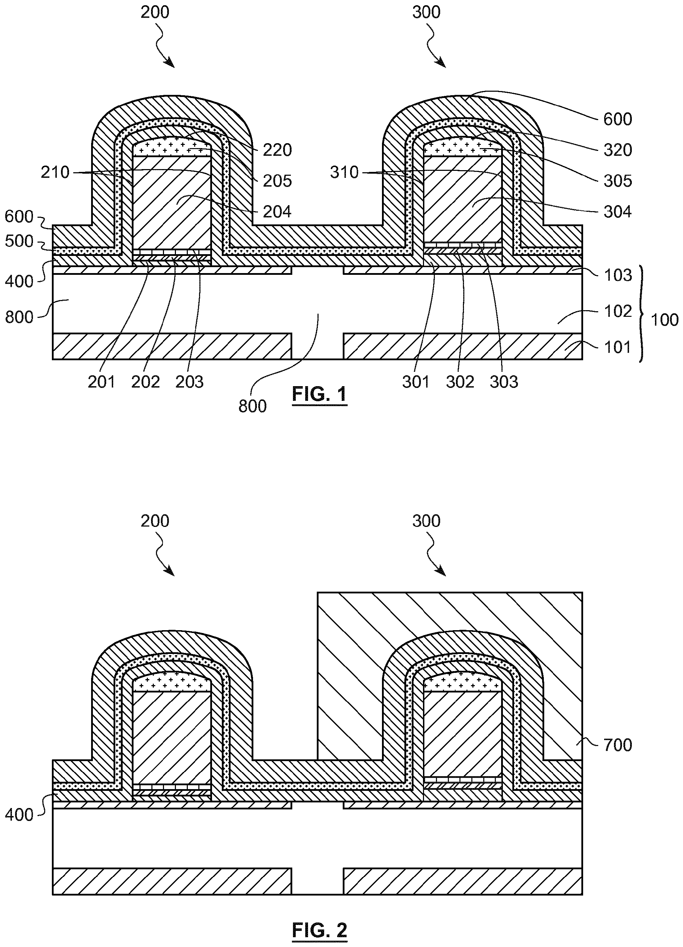

En référence aux figures 1 à 13, un exemple de procédé selon l'invention va maintenant être décrit.

La figure 1 illustre une structure à partir de laquelle les étapes du procédé selon l'invention sont mises en oeuvre. Cette structure comprend des transistors en cours de formation.

Cette structure comprend :
- un substrat élaboré 100 de type semi-conducteur sur isolant (SOI) et de préférence de type silicium sur isolant. Sur l'exemple illustré ce substrat élaboré 100 comprend successivement une couche de support 101 ; par exemple en silicium monocristallin, polycristallin ou amorphe; une couche isolante 102, habituellement qualifiée d'oxyde enterré (BOX pour Buried Oxide en anglais) et une couche active 103 semi-conductrice destinée à former un canal de conduction d'un transistor. Cette dernière est par exemple en silicium (Si), en germanium (Ge) ou en silicium-germanium (SiGe), de préférence monocristallin. De préférence, l'épaisseur de la couche active 103 formant un canal de conduction pour le transistor est comprise entre 4 et 11 nm (10⁻⁹ mètres) et de préférence entre 6 et 8 nm.
   - des motifs 200, 300 de grille. Dans l'exemple illustré, non limitatif, les motifs 200, 300, de grille forment chacun un empilement de plusieurs couches. Ces motifs 200, 300 sont destinés à être conservés dans les transistors finaux (procédé de type gate first). Selon un mode de réalisation alternatif non illustré, les motifs 200, 300 de grille sont des motifs sacrificiels qui sont destinés à être retirés après réalisation des espaceurs, puis à être remplacés par une autre grille formant de préférence un empilement (procédé de type gate last). L'invention couvre ce mode de réalisation alternatif.
   - Dans la suite de la description, qui illustre un mode de réalisation de type gate first en référence aux figures, on utilisera aussi bien le terme empilement que motif.
- Typiquement, les empilements de grille comprennent comprenant chacun au moins une grille 204, 304 habituellement en silicium polycristallin ou en métal et une couche isolante habituellement qualifiée d'oxyde de grille 201, 301 située sous la grille 204, 304 et au travers de laquelle un champ électrique va pouvoir se développer pour créer un canal de conduction sous-jacents entre source et drain quand une tension suffisante est appliquée sur la grille 204, 304.

De manière préférée, l'empilement de grille comprend également :
- une couche métallique souvent qualifiée de grille métallique 203, 303 et située entre la grille 204, 304 et l'oxyde de grille 201, 301 ;
- une couche diélectrique 202, 302, dite « high-k », c'est-à-dire faite d'un matériau à haute permittivité. Cette couche est située entre l'oxyde de grille 201, 301 et la grille métallique 203, 303.
- un masque dur 205, 305 de protection qui sera enlevé ultérieurement pour permettre la reprise de contact sur la grille 204, 304. Ce masque dur 205, 305, qui reste en place après gravure de la grille 204, 304, est typiquement fait de SiO2 ou de nitrure de silicium (SiN). Son rôle est de protéger le sommet de la grille 204, 304 de tout dommage lors de la réalisation des étapes suivantes et notamment celles de gravure des espaceurs. On peut trouver une fine couche d'oxyde entre le silicium polycristallin de la grille et le masque dur nitrure.

De préférence, la couche isolante d'oxyde de grille 201, 301 est disposée au contact de la couche active 103 formant le canal de conduction et au contact de la couche à haute permittivité 202, 302. De préférence, la couche métallique 203, 303 est disposée au contact de la couche à haute permittivité 202, 302 et au contact de la grille 204, 304.

Selon un autre mode de réalisation la couche métallique 203, 303 et/ou la couche à haute permittivité 202, 302 sont absentes.

Selon un autre mode de réalisation, le masque dur 205, 305 et une couche de protection 400 détaillée par la suite sont tous deux formés en nitrure de silicium (SiN).

Un même substrat élaboré 100 supporte une pluralité de transistors et donc d'empilements de grille. Pour certaines applications, il est nécessaire d'avoir des transistors dont les propriétés sont différentes. Ainsi, certains transistors doivent présenter un oxyde de grille 301 dont l'épaisseur est plus importante que celle de l'oxyde de grille 201 d'autres transistors.

La figure 1 représente ainsi un empilement de grille 300 dont l'épaisseur de l'oxyde de grille 301 est supérieure à celle de l'oxyde de la grille 201 de l'empilement 200.

A titre d'exemple non limitatif, on peut ainsi avoir sur un même substrat élaboré 100 :
- des transistors dont l'oxyde de grille présente une épaisseur comprise entre 0 et 1,5 nm. Ces transistors sont connus pour fonctionner à une tension Vdd comprise entre 0,8V et 1V. Ces transistors sont parfois qualifiés de SG ou de GO1.
   L'épaisseur des espaceurs est mesurée perpendiculairement au plan contenant les flancs 210, 310 des grilles 204, 304, i.e. dans cet exemple, selon une direction parallèle au plan principal dans lequel le substrat 100 s'étend. Cette épaisseur est donc mesurée horizontalement sur les figures.
- des transistors dont l'oxyde de grille présente une épaisseur comprise entre 2 et 5 nm, et plus souvent entre 2 et 3,5 nm. Ces transistors sont connus pour fonctionner à une tension Vdd comprise entre 1,5V et 3,5V. Ainsi la tension de claquage pour ces transistors est plus élevée que la tension maximale appliquée à l'oxyde de grille. Ces transistors sont parfois qualifiés de EG ou GO2.
- des transistors dont l'oxyde de grille présente une épaisseur comprise entre 3 et 6 nm sont connus pour fonctionner à une tension Vdd supérieure à 3V. Ainsi la tension de claquage pour ces transistors est plus élevée que la tension maximale appliquée à l'oxyde de grille. Ces transistors sont parfois qualifiés de ZG ou GO3.
- La structure illustrée en figure 1 montre également la présence de tranchée d'isolation 800 traversant toute la couche active 103 pour isoler deux transistors adjacents. Ces tranchées d'isolation 800 s'étendent à travers toute l'épaisseur de la couche active 103 et jusque dans la couche de support 101. Ces tranchées d'isolation sont typiquement réalisées en oxyde, typiquement en SiO2.
- La structure illustrée en figure 1 montre également la présence de couches de protection destinées à former des espaceurs sur les flancs 210, 310 des grilles 204, 304.

Ces couches de protection 400, 500, 600 sont au nombre de trois sur cet exemple de réalisation. Néanmoins, on pourrait en avoir uniquement deux ou en avoir quatre ou plus.

Pour maintenir des performances élevées, en particulier au niveau des transistors dont les oxydes de grille sont fins, il est nécessaire d'avoir des espaceurs fins.

Typiquement, pour des transistors dont les oxydes de grille 201 ont une épaisseur de l'ordre de 0 à 1,5 nm, l'épaisseur totale des couches formant un espaceur sur les flancs des empilements 200 de grilles doit de préférence présenter une épaisseur inférieure à 9 nm.

Par ailleurs, afin de limiter la complexité des procédés et d'en limiter leur coût, il est préférable que les espaceurs de transistors de deux types différents soient réalisés au cours des mêmes étapes.

Cela conduit à ce que, dans les procédés connus, les espaceurs des transistors ayant des oxydes de grille plus épais soient également inférieurs à 9 nm.

Dans le cadre du développement de la présente invention, il a été identifié que cette épaisseur conduit souvent à un claquage au niveau des espaceurs des transistors à oxyde de grille épais, détériorant de ce fait la fiabilité et la durée de vie des dispositifs intégrant ce type de transistors.

Les étapes qui suivent permettent de remédier à ce problème en formant des espaceurs plus épais sur les flancs 310 des empilements 300 dont l'oxyde de grille 301 est plus épais, tout en limitant la complexité du procédé.

Les couches de protection illustrées en figure 1 comprennent :
- Une couche de protection 400, habituellement qualifiée de « spacer 0 ». Elle est par exemple en nitrure de silicium (SiN) ou en un matériau à faible constante diélectrique (k inférieure à 7). Elle peut par exemple être en un matériau poreux.
   Dans le cadre de la présente invention, on désigne par couche poreuse, une couche dont la présence de vide dans le film est supérieure à 5% et de préférence comprise entre 5 et 10%.
   Cette couche de protection 400 présente une épaisseur comprise entre 3 et 10 nm sans que cela soit limitatif et de préférence de l'ordre de 4 à 8 nm.
- Une couche de protection 500, habituellement qualifiée de « spacer 1 ». Cette couche présente une épaisseur comprise entre 2 et 6 nm sans que cela soit limitatif et de préférence de l'ordre de 3 nm. Elle est par exemple en oxyde, par exemple en oxyde de silicium (SiO2 et plus généralement (SixOy). Cette couche est de préférence obtenue par dépôt. Avantageusement, pour densifier l'oxyde, on effectue une étape de recuit thermique, par exemple de type spike anneal. Une telle étape permet de monter haut en température sur une durée très courte (maximum une seconde). La densification de l'oxyde peut se faire également naturellement lors du dépôt de la couche 600, qui se fait typiquement à une température de l'ordre de 630°C sur un durée supérieure à 10 minutes.
- Une couche de protection 600, habituellement qualifiée de « spacer 2 ». Cette couche présente une épaisseur comprise entre 2 et 16 nm sans que cela soit limitatif et de préférence de l'ordre de 10 nm. Elle est par exemple en nitrure de silicium (SiN). ou en un matériau à faible constante diélectrique (k inférieure à 7). Elle peut par exemple être en un matériau poreux.

Les couches 400 et 600, lorsqu'elles sont en un matériau low-k, i.e. à faible permittivité, comprennent généralement au moins l'une des espèces suivantes ou une combinaison de ces espèces : silicium (Si), carbone (C), bore (B), azote (N), hydrogène (H). Elles sont par exemple formées dans l'un des matériaux suivants : SiCO, SiC, SiCN, SiOCN ou SiCBN. Ces couches sont poreuses ou non.

La constante diélectrique de ces couches se mesure par exemple par la méthode classique dite de la goutte de mercure.

Les couches 400, 500, 600 sont toutes obtenues par un dépôt conforme, c'est-à-dire qu'elles présentent une épaisseur constante sur toute la plaque et en particulier sur les flancs 210, 310 et les sommets 220, 320 des empilements 200, 300 de grille ainsi qu'en dehors des empilements 200, 300 de grille.

La figure 2 illustre une étape suivante au cours de laquelle on forme une couche de masquage 700 pour recouvrir entièrement le deuxième empilement 300 de grille, c'est-à-dire celui présentant une épaisseur d'oxyde de grille 301 supérieure à celle du premier empilement 200. Cette couche de masquage 700 est typiquement une couche de résine, déposée pleine plaque, puis ouverte au niveau du premier empilement 200 par l'une des techniques conventionnelles de lithographie.

Dans le cadre de la présente invention, on qualifie de résine un matériau organique ou organo-minéral pouvant être mis en forme par une exposition à un faisceau d'électrons, de photons ou de rayons X ou mécaniquement.

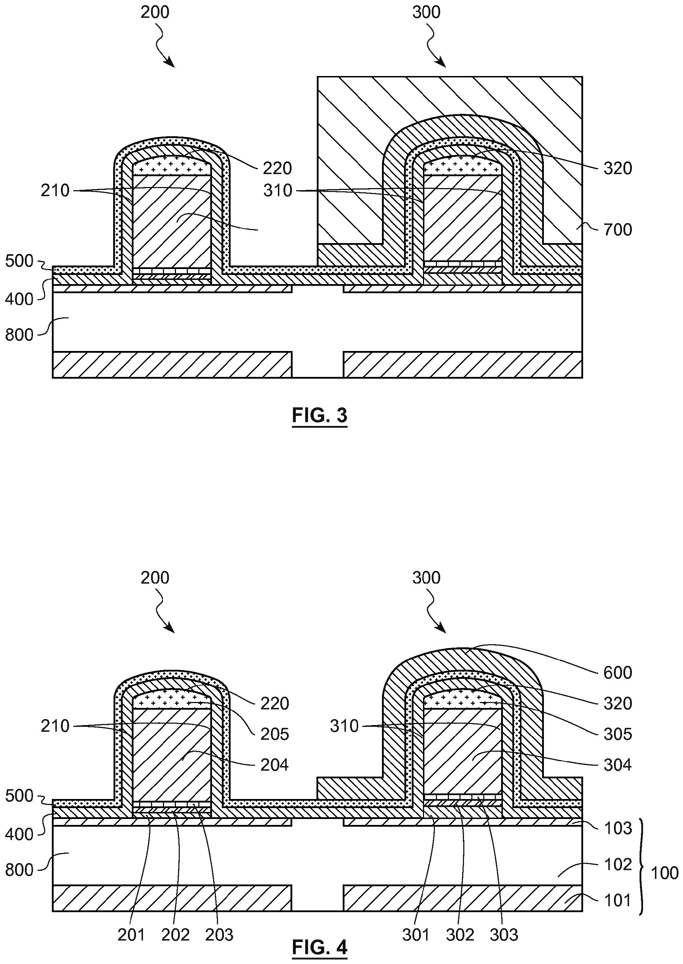

L'étape suivante, dont le résultat est illustré en figure 3, vise à retirer la deuxième couche de protection 600 qui recouvre le premier empilement 200 de grille. Comme illustré en figure 3, cette étape est de préférence effectué de manière à retirer entièrement la portion de la deuxième couche de protection 600 qui est située sur le premier motif 200 de grille.

Pour cela, on effectue une gravure de cette couche 600 sans graver la première couche de protection 500. Par ailleurs la deuxième couche de protection 600, protégée par la couche de masquage 700, demeure en place.

Par exemple, si la première couche de protection 500 est en SiO2 et la deuxième couche de protection 600 est en nitrure de silicium, on retirera cette dernière couche sélectivement à la première couche de protection 500 par gravure humide, par exemple avec une solution à base de H3PO4. On peut également et préférentiellement retirer la deuxième couche de protection 600 par une gravure sèche effectuée par exemple dans un réacteur à couplage inductif (ICP), capacitif (CCP) ou à micro-ondes. Si cette couche 600 est en SiN ou en matériau à constante diélectrique inférieure à 7, on utilisera par exemple une chimie à base de fluor telle qu'une chimie fluorée ou fluorocarbonée. Ce type de gravure permet d'être très sélectif vis-à-vis du SiO2 qui est un bon candidat pour la première couche de protection 500. De préférence on règlera les paramètres afin d'obtenir une gravure isotrope. On abaissera la tension de polarisation (bias) dans le cas d'un plasma à couplage inductif ou capacitif. On pourra également pulser la tension de polarisation et/ou la tension de la source pour améliorer l'isotropie de la gravure.

A titre d'exemple, la chimie fluorée peut être à base de CxFyHz, SF6 ou NF3 dilué ou non avec d'autres gaz tels que HBr, N2, Ar, He, H2, CxHyHz. Par exemple on choisira une gravure réalisée dans un réacteur à couplage inductif, pour une pression de 90mTorr, 600W de puissance source, 50sccm de SF6, 50sccm de HBr, température de substrat de 60°C, le temps sera à ajuster en fonction de l'épaisseur de nitrure à graver.

Comme illustré en figure 4, la couche de masquage 700 est ensuite retirée. Naturellement, ce retrait est sélectif du matériau de la première couche 500 afin de conserver cette dernière sur le premier empilement 200. Lorsque cette couche de masquage 700 est une résine photosensible, elle est par exemple retirée dans un réacteur à couplage capacitif, ou à couplage inductif ou à micro-ondes en utilisant une chimie oxydante ou réductrice. Par exemple, on peut injecter un mélange gazeux de N2 et H2 dans un réacteur plasma pour la gravure, puis effectuer un nettoyage humide afin de retirer les résidus de résine. Ce nettoyage peut être effectué à l'aide d'une solution SC1.

A ce stade, l'épaisseur initiale de la première couche 500 est conservée dans sa totalité ou est tout au plus très peu consommée.

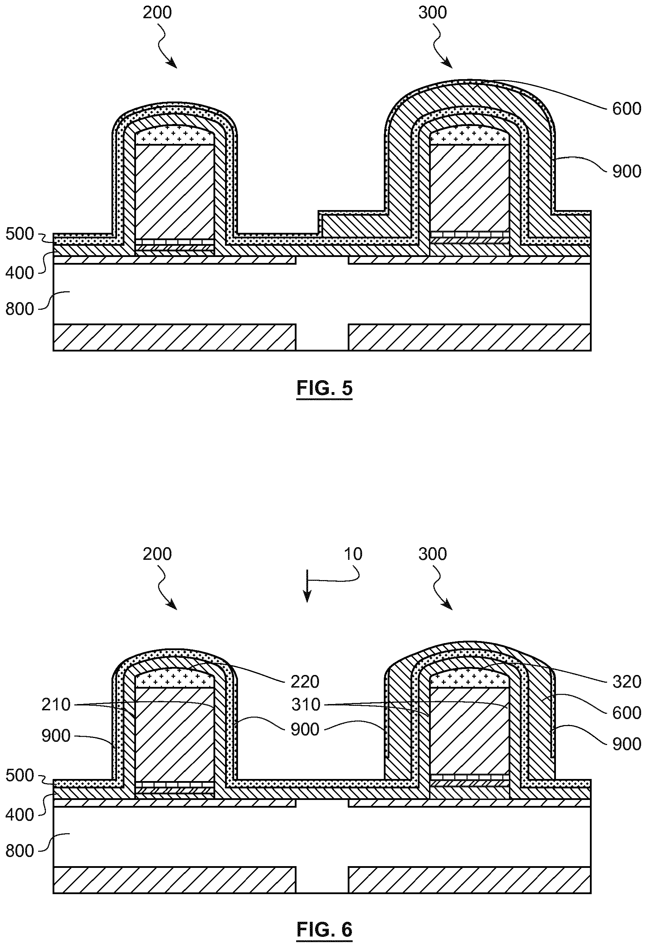

Les figures 5 à 7 visent à graver de manière anisotrope la deuxième couche 600 afin de supprimer ou réduire l'épaisseur de cette couche 600 sur le sommet 320 du deuxième empilement 300 tout en conservant une forte épaisseur de cette couche 600 sur ses flancs 310 et sans altérer significativement la première couche de protection 500.

La figure 5 illustre une étape avantageuse mais uniquement optionnelle. Elle vise à protéger la deuxième couche de protection 600 au niveau des flancs 310 du deuxième empilement 300. Pour cela, un film protecteur d'oxyde 900 est formé à la surface de cette couche 500. Par exemple, on injecte du O2 dans un réacteur plasma ICP ou CCP avec les paramètres suivants :
- Pression : 10 milli Torr
- Puissance de la source:1000 Watts
- Débit de O2 : 200 sccm (centimètres cube par minute dans des conditions standard de pression et de température). Typiquement un débit se mesure avec un débitmètre associé au réacteur.
- Température du substrat 60°C
- Durée : 30 secondes

Ces conditions provoquent la formation d'un film d'oxyde 900 d'environ 1 à 2 nm à la surface de la plaque, c'est-à-dire à la surface de la deuxième couche de protection 600 ainsi qu'à la surface de la première couche de protection 500.

La figure 6 illustre une étape de gravure anisotrope effectuée selon une direction privilégiée 10 qui est perpendiculaire au plan principal dans lequel s'étend le substrat 100. Ainsi, au cours de cette gravure anisotrope, le film protecteur 900, s'il est présent, est retiré sur les surfaces parallèles au plan principal dans lequel s'étend le substrat 100. Ce film protecteur 900 est retiré sur les sommets 220, 320 des empilements 200, 300 et entre les empilements 200, 300.

Cette gravure anisotrope retire également une partie de l'épaisseur de la deuxième couche de protection 600 située sur le sommet 320 du deuxième empilement 300.

Cette gravure grave la deuxième couche de protection 600 beaucoup plus rapidement que la première couche de protection 500, si bien qu'à l'issue de cette gravure anisotrope, l'épaisseur de la première couche de protection 500 n'est pas du tout consommée ou n'est gravée que partiellement sur le sommet 220 du premier empilement 200.

Par exemple, la gravure anisotrope retire tout le film protecteur 900 sur le sommet 220, 320 des empilements 200, 300 et entre ces derniers et consomme environ 3 nm de la deuxième couche de protection 600 sur le sommet 320 du deuxième empilement 300. Il reste alors une épaisseur de 1 nm de la deuxième couche 600 sur le sommet 320.

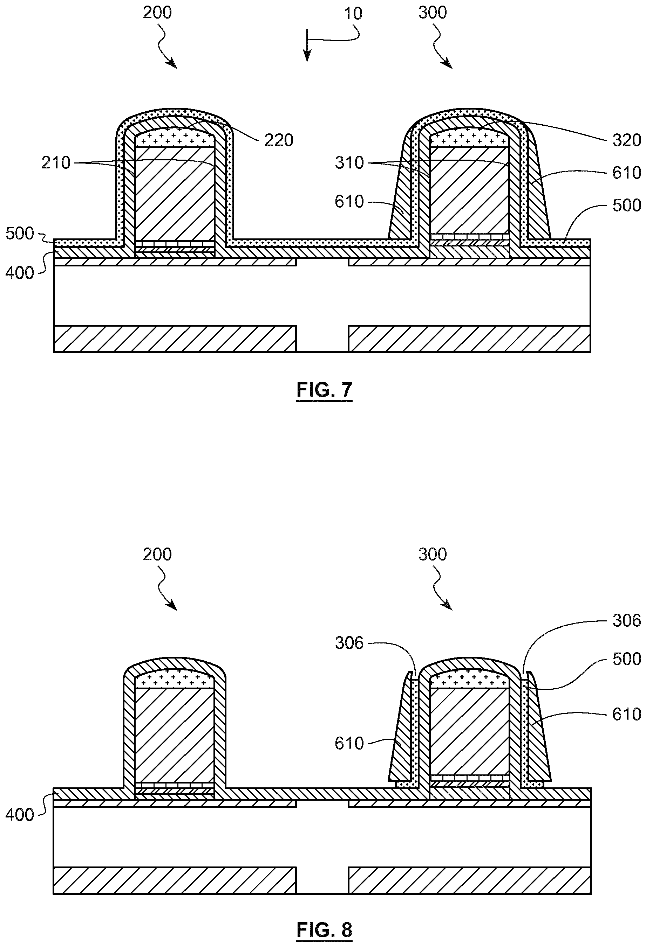

La figure 7 illustre une étape de surgravure pour retirer l'épaisseur de la deuxième couche de protection 600 qui subsiste sur le sommet 320 du deuxième empilement 300. Cette épaisseur résiduelle est d'environ 1 nm dans cet exemple non limitatif. Cette gravure est sélective du matériau de cette couche 600 vis-à-vis de celui de la première couche 500 qui n'est pas ou que peu consommée. Comme cela apparaît en figure 7, la deuxième couche 600 est alors retirée partout à l'exception des flancs 310 du deuxième empilement 300. Les portions résiduelles 610 de la deuxième couche de protection 600 forment alors des espaceurs 610. Cette gravure est de préférence anisotrope.

On notera que selon un mode de réalisation le procédé on passe directement de l'étape illustrée en figure 4 à l'étape illustrée en figure 7. Tel est notamment le cas lorsque l'on ne réalise pas le film protecteur 900. Selon ce mode de réalisation simplifié, on effectue directement une gravure anisotrope à partir de l'étape illustrée en figure 4 afin d'obtenir la structure illustrée en figure 7. Alternativement, on peut, toujours, sans réaliser le film protecteur 900, effectuer une gravure anisotrope de la deuxième couche de protection 600 et effectuer, avant ou après cette gravure, une gravure isotrope de deuxième couche de protection 600.

On notera que la gravure effectuée de manière à retirer la deuxième couche de protection 600 sur le sommet du deuxième motif 300, peut éventuellement conduire à consommer une partie de l'épaisseur de la première couche de protection 500 située sur le premier empilement 200 de grille et notamment sur le sommet de ce dernier. Néanmoins, cette consommation partielle n'est pas préjudiciable car, comme cela sera expliqué par la suite, la gravure de la première couche de protection 500 est très sélective vis-à-vis du matériau de la troisième couche de protection 400. Tel est par exemple le cas lorsque la première couche de protection 500 est un oxyde de silicium SixOy et la troisième couche protection 400 est en nitrure de silicium SixNy. Par conséquent, lors du retrait de la première couche de protection 500 sur les premiers et deuxièmes motifs de grille 200, 300 la gravure s'arrêtera simultanément sur ces deux motifs 200,300 et sans consommer la troisième couche de protection 400 sur le premier motif 200.

La figure 8 illustre le retrait de la première couche de protection 500.Ce retrait laisse apparaître la troisième couche de protection 400, destinée à former les espaceurs pour le premier empilement 200, c'est-à-dire l'empilement présentant une épaisseur faible d'oxyde de grille 201.

De manière particulièrement avantageuse, la deuxième couche de protection 500 est entièrement retirée au moins sur le premier empilement ou motif 200. Par conséquent, les flancs 210 du premier motif 200 sont recouverts par la troisième couche de protection 400 et de préférence uniquement par cette troisième couche protection 400. Cela permet de préserver l'épaisseur de l'espaceur standard formé par la troisième couche de protection 400. Cela permet notamment de ne pas avoir à modifier le procédé standard concernant les étapes particulièrement critiques de définition de l'épaisseur des espaceurs sur les empilements de grille dont les flancs sont recouverts par un espaceur monocouche.

Dans le cas où la première couche de protection 500 est un oxyde tel que le SiO2, ce retrait est avantageusement réalisé par gravure humide, par exemple avec une solution diluée d'HF.

Cette gravure grave la première couche 500 sélectivement aux espaceurs 610 de la deuxième couche 600 et à la troisième couche 400, si bien que cette dernière n'est que peu et de préférence n'est pas du tout gravée.

Il résulte de cette étape que de légères cavités 306 peuvent apparaitre entre les espaceurs 610 et la troisième couche 400 là où la première couche 500 est accessible.

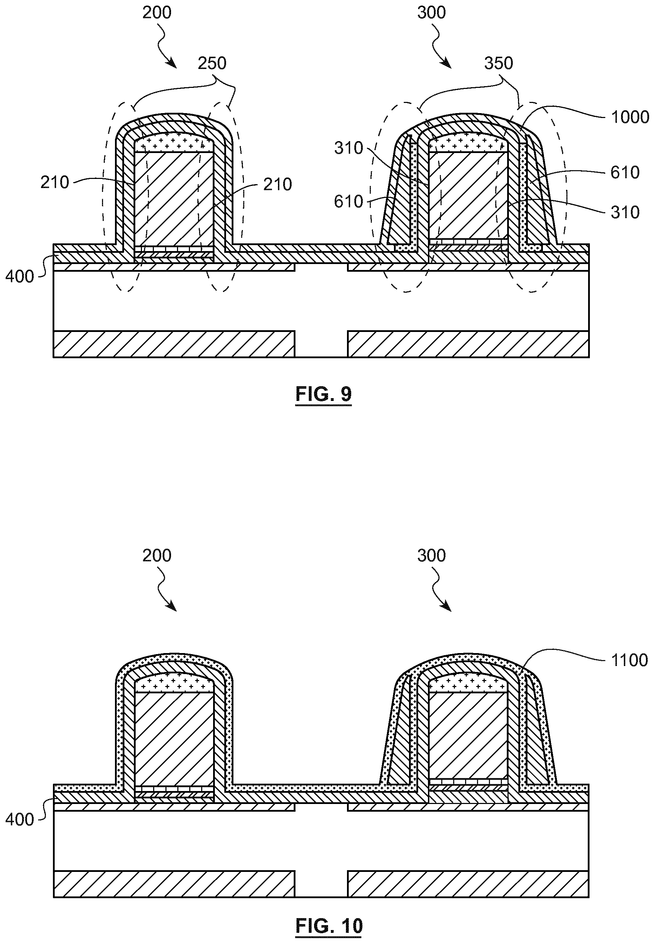

Comme illustré en figure 9, afin de protéger la première couche de protection 500, on peut prévoir d'encapsuler cette dernière en formant une couche d'encapsulation 1000 qui comble ces cavités 306.

Cette couche d'encapsulation 1000 est par exemple une couche de nitrure (SiN par exemple) ou une couche low-k c'est-à-dire dont la constante diélectrique est inférieure à 7.

Dans ce cas, l'épaisseur de la troisième couche de protection 400 doit être choisie pour obtenir, après dépôt de la couche d'encapsulation 1000, l'épaisseur souhaitée pour protéger les flancs 210 du premier empilement 200.

Comme illustré en figure 9, le premier empilement 200 présente sur ses flancs 210 des espaceurs 250 constitués par les couches suivantes :
- Troisième couche de protection 400 et optionnellement la couche d'encapsulation 1000 ;

Le deuxième empilement 300 présente sur ses flancs 310 des espaceurs 250 constitués par les couches suivantes :
- Troisième couche de protection 400, première couche de protection 500, espaceurs 610 formés par la deuxième couche de protection 600 et optionnellement la couche d'encapsulation 1000. Ainsi les flancs 310 de l'empilement de grille 300 présentant un oxyde de grille 301 plus épais sont protégés par une épaisseur d'espaceur bien plus importante que les flancs 210 de l'empilement 200 dans lequel l'oxyde de grille 201 est fin.

On remarque que la structure obtenue présente pour avantage que la couche active 103 est, en dehors des empilements de grille 200, 300, surmontée par une couche 400 d'épaisseur constante sur la plaque. Par conséquent, une même gravure anisotrope de la troisième couche de protection 400 permet de retirer cette dernière de part et d'autres des empilements 200, 300 afin de mettre à nu la couche active 103 en vue de la formation des source et drain, typiquement par épitaxie à partir de la couche active 103. Le fait qu'avant la gravure cette troisième couche 400 présente une épaisseur constante permet de bien contrôler sa gravure pour la retirer entièrement mais sans altérer la couche active 103 sous-jacente.

Par exemple, pour retirer la troisième couche de protection 400 entre les empilements 200, 300, on peut procéder aux étapes suivantes, si cette couche 400 est en nitrure de silicium (SiN) ou en matériau low-k.
- Dépôt d'un film protecteur 1100 comme illustré en figure 10. Sur cette figure, pour des raisons de clarté, la couche d'encapsulation 1000 optionnelle n'est pas représentée. Naturellement si cette couche d'encapsulation 1000 est formée comme illustrée en figure 9 elle sera présente sous le film protecteur 1100. Ce film protecteur 1100 est par exemple obtenu par dépôt par plasma d'un film d'oxyde sur toute la plaque. De préférence, ce film protecteur 1100 est réalisé dans le même réacteur que la gravure anisotrope subséquente de la troisième couche de protection 400. Il recouvre les flancs 210, 310, les sommets 220, 320 des empilements de grille 200, 300 ainsi que les régions entre les empilements 200, 300.

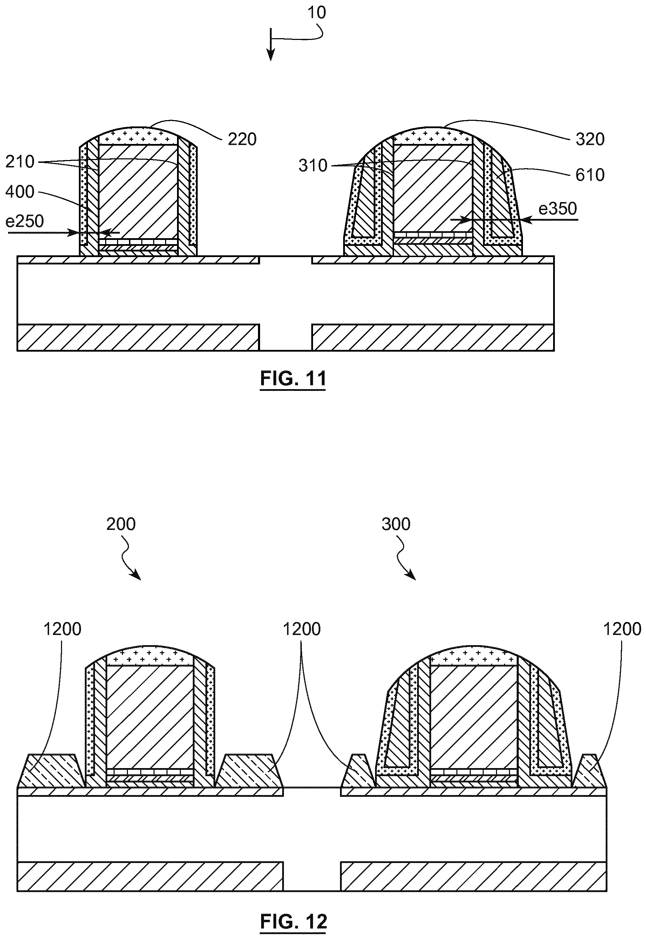

Par exemple, les conditions suivantes sont appliquées dans un réacteur plasma de type ICP:
- Pression : 10 milli Torr
- Puissance de la source: 1000 Watts
- Débit de O2 : 200 sccm
- Température du substrat 60°C
- Retrait du film protecteur 1100 dans le fond de la structure et par voie de conséquence sur les sommets 220, 320 des empilements 200, 300 en le conservant sur les flancs 210, 310. Cette étape est illustrée en figure 11.
Ce retrait comprend de préférence une gravure anisotrope selon une direction privilégiée 10 parallèle aux flancs 210, 310. Cette gravure est par exemple effectuée à l'aide d'un plasma fluoré ou fluorocarboné. Les conditions peuvent par exemple être les suivantes:
Gravure Principale:
   - Pression : 5 milli Torr
   - Puissance de la source:300 Watts
   - Tension de polarisation (bias) : 65 volts
   - Débit de CHF₃ : 30 sccm
   - Débit de He : 220 sccm
Température 110°C

Avec ces conditions la vitesse de gravure de la troisième couche de protection 400 en nitrure de silicium est de l'ordre de 30nm/min.

On peut ensuite effectuer une étape de sur-gravure sélective au Si et SiO2, par exemple avec les conditions suivantes
- Pression : 90 milli Torr
- Puissance de la source:400 Watts
- Tension de polarisation (bias) Vb : 250 volts
- Débit de CHF₃ : 200 sccm
- Débit de O₂ : 200 sccm
- Débit de He : 120 sccm
- Débit de CH4 : 20 sccm
- Température du substrat 60°C
- Pulsation de la polarisation (bias) 50%
- Fréquence 500Hz
   - Retrait de matériau de la troisième couche de protection 400 sélectivement au film protecteur 1100 en oxyde. Cette gravure doit être fortement sélective vis-à-vis du film protecteur 1100 afin que ce dernier protège efficacement les espaceurs déjà formés. Cette gravure est également fortement sélective vis-à-vis du matériau de la couche active 103 destinée à former le canal afin de ne pas consommer ou dégrader cette dernière.
La gravure n'ayant pas une sélectivité infinie par rapport au film protecteur 1100, ce dernier est malgré tout consommé au cours de la gravure. Ce film 1100 permet cependant un meilleur contrôle du dimensionnel en retardant l'effet de l'attaque latérale, ceci même pour une gravure anisotrope.

A ce stade du procédé, il ne reste des épaisseurs de la première couche de protection 500, la deuxième couche de protection 600 et la troisième couche de protection 400 que sur les flancs 310 du deuxième empilement 300. Par ailleurs, sur les flancs 210 du premier empilement 200 il ne reste que la troisième couche 400.

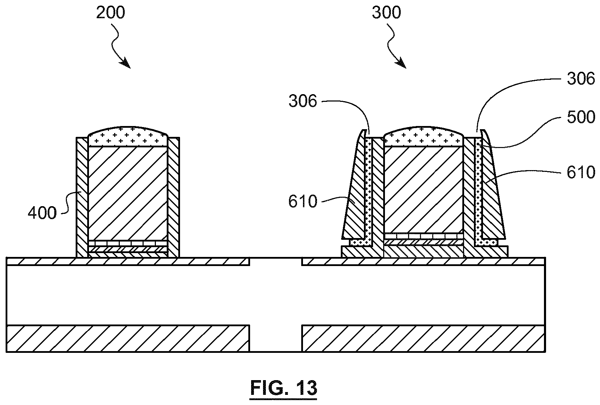

Selon un autre mode de réalisation, les étapes décrites en référence aux figures 9 et 10 sont remplacées par une étape de gravure anisotrope de la troisième couche de protection 400 selon la direction privilégiée 10. Par conséquent, selon ce mode de réalisation, l'étape illustrée en figure 13 fait suite à l'étape illustrée en figure 8.Cette gravure est une gravure sèche. Le résultat de cette gravure est illustrée en figure 13. La troisième couche de protection 400 est retirée sur les sommets et entre les empilements 200, 300. En revanche elle subsiste sur les flancs 210 du premier empilement 200 (ainsi que sur les flancs 310 du deuxième empilement 300 puisque ces derniers sont recouverts par les autres espaceurs formés par les première 500 et deuxième 600 couches). Les étapes mentionnées ci-dessous peuvent être effectuées à partir du résultat de l'étape illustrée en figure 13. Ce mode de réalisation a notamment pour avantage de réduire le nombre d'étapes et d'être ainsi moins couteux.

Comme illustré en figure 13, la troisième couche de protection 400 est destinée à former un espaceur qui sera conservé sur les flancs du premier empilement 200 de grille lors du fonctionnement du transistor. La troisième couche de protection 400 forme ainsi un espaceurs fonctionnel.

Concernant le deuxième empilement 300 de grille, les espaceurs formés par les première 500; deuxième 600 et troisième 400 couches sont conservés. Ainsi, ces couches forment des espaceurs fonctionnels. Elles seront de préférence présentes sur ce deuxième empilement 300 de grille dans le transistor final.

A ce stade du procédé, les épaisseurs totales des espaceurs sont par exemple, les suivantes:
- Premier empilement 200 avec oxyde de grille 201 fin : e250 = 6nm
- Deuxième empilement 300 avec oxyde de grille 301 épais e350 = 20nm.
Comme illustré en figure 11, ces épaisseurs sont prises perpendiculairement au plan principal dans lequel s'étendent les flancs 210, 310 des empilements de grille 200, 300

Ainsi l'épaisseur totale d'espaceur pour les transistors à oxyde de grille épais est environ trois fois plus élevée que pour les transistors à oxyde de grille fin. Cela permet d'éviter les risques de claquage.

De manière avantageuse mais uniquement optionnelle, on effectue un dopage par implantation inclinée (dopage tilté) des flancs de l'empilement 300 présentant un oxyde de grille plus épais afin de doper la région de la couche 103 située sous l'espaceur. Ce dopage permet de conserver ou d'améliorer les performances de ce transistor. Ce dopage comprend par exemple l'implantation d'espèces Arsenic (As), Phosphore (P) pour un transistor de type N, ou Bore (B), difluorure de bore (BF2), ou Indium pour un transistor de type Pdans la région du canal située sous l'espaceur plus épais

Les espaceurs sont formés de part et d'autre des empilements 200, 300. On peut ensuite mettre en oeuvre des étapes classiques pour finaliser la réalisation des transistors.

Parmi ces étapes classiques, on pourra par exemple prévoir la croissance des source et drain 1200 par épitaxie à partir de la couche active 103 comme illustré en figure 12. On prévoira également, en fonction des applications, la protection des transistors de type P (ou N) par dépôt d'une résine. Cette étape est de préférence effectuée avant la formation du film protecteur 1100 d'oxyde illustré en figure 10.

Au vu de la description qui précède, il apparaît clairement que le procédé selon l'invention permet d'améliorer la durée de vie des dispositifs intégrant sur une même puce des transistors dont les épaisseurs de grille sont différentes, sans pour autant augmenter de manière significative la complexité du procédé de fabrication.

L'invention n'est pas limitée aux modes de réalisation précédemment décrits et s'étend à tous les modes de réalisation couverts par les revendications.

Par exemple on pourra inverser l'ordre de certaines étapes. Par exemple l'étape de gravure anisotrope de la deuxième couche de protection 600 peut être effectuée avant masquage du deuxième empilement 300. Dans ce cas, la deuxième couche de protection 600 est retirée, entièrement ou partiellement, sur les sommets 220, 320 des deux empilements 200, 300. Cette couche est en revanche conservée sur les flancs 210, 310 des deux empilements 200, 300. Après cette gravure anisotrope, on effectue l'étape de masquage du deuxième empilement 300 afin de permettre la gravure isotrope de la deuxième couche 600 recouvrant le premier empilement 200, en particulier au niveau de ses flancs 210.

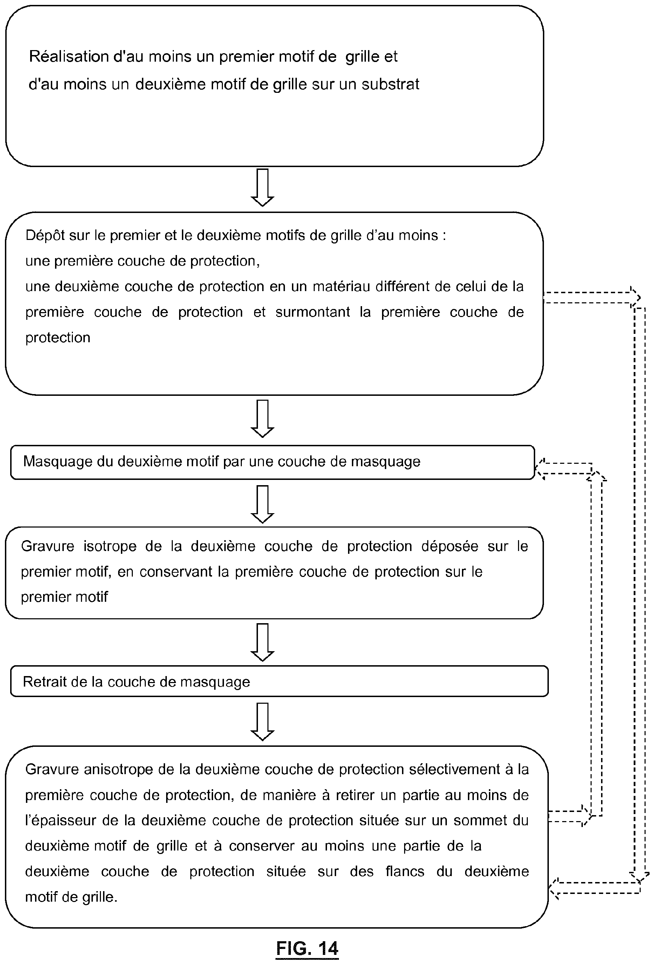

Ce mode de réalisation alternatif est illustré en figure 14 par les flèches en pointillés.

Les détails, exemples et avantages des étapes du mode de réalisation décrit en détail en référence aux figures 1 à 12 s'appliquent à ce mode de réalisation alternatif dans lequel l'étape de gravure anisotrope de la deuxième couche de protection 600 est effectuée avant masquage du deuxième empilement 300.

Par rapport au mode de réalisation illustré sur les figures, ce mode de réalisation alternatif présente les avantages suivants :
Bien que l'invention soit particulièrement avantageuse pour réaliser sur un même substrat des transistors dont les empilements de grille présentent des couches isolantes (typiquement une couche d'oxyde de grille) d'épaisseurs différentes, cela n'est pas limitatif. En effet l'invention s'applique également à la réalisation sur un même substrat de transistors dont les empilements de grille présentent des couches isolantes d'épaisseurs identiques.

Par ailleurs, dans les modes de réalisation illustrés, l'empilement de grille est réalisé préalablement aux étapes de l'invention. Ces figures illustrent ainsi un procédé de type gate first.

Selon un autre mode de réalisation couvert par l'invention, l'empilement fonctionnel de grille est réalisé postérieurement aux étapes de l'invention. L'empilement de grille sur lequel est déposée la première couche de protection forme donc un motif sacrificiel qui sera retiré, une fois les espaceurs réalisés. Ce mode de réalisation alternatif est ainsi un procédé de type gate last.

### REFERENCES

- 100: Substrat élaboré
- 101: Couche porteuse
- 102: Couche isolante
- 103: Couche active

- 200: Premier empilement/Motif
- 201: Couche isolante du premier empilement
- 202: Couche à haute permittivité du premier empilement
- 203: Grille métallique du premier empilement
- 204: Grille du premier empilement
- 205: Masque dur du premier empilement
- 210: Flanc du premier empilement
- 220: Sommet du premier empilement
- 250: Espaceur du premier empilement

- 300: Deuxième empilement/Motif
- 301: Couche isolante du deuxième empilement
- 302: Couche à haute permittivité du deuxième empilement
- 303: Grille métallique du deuxième empilement
- 304: Grille du deuxième empilement
- 305: Masque dur du deuxième empilement
- 306: Cavité
- 310: Flanc du deuxième empilement
- 320: Sommet du deuxième empilement
- 350: Espaceur du deuxième empilement

- 400: Troisième couche de protection

- 500: Première couche de protection

- 600: Deuxième couche de protection
- 610: Portion de deuxième couche de protection

- 700: Couche de masquage
- 800: Tranchée d'isolation
- 900: Film protecteur
- 1000: Couche d'encapsulation
- 1100: Film protecteur
- 1200: Source/Drain

## Revendications

1. Procédé de réalisation sur un même substrat (100) de type semi-conducteur sur isolant (SOI) ou semiconducteur-sur-isolant totalement déserté (FDSOI) d'au moins un premier transistor et d'au moins un deuxième transistor, le procédé comprenant au moins les étapes suivantes :
- Réalisation sur un substrat (100) d'au moins un premier motif (200) de grille et d'au moins un deuxième motif (300) de grille;
- Dépôt sur le premier et le deuxième motif (200, 300) de grille d'au moins :
• une première couche de protection (500),
• une deuxième couche de protection (600) surmontant la première couche de protection (500) et faite en un matériau différent de celui de la première couche de protection (500)
• une troisième couche de protection (400) surmontée de la première couche de protection (500) et de la deuxième couche de protection (600), la troisième couche de protection (400) étant en un matériau permettant une gravure du matériau de la première couche de protection (500) sélectivement au matériau de la troisième couche de protection (400) et;
la deuxième couche de protection (600) et la troisième couche de protection (400) sont chacune faites en un matériau prise parmi les matériaux suivants : nitrure de silicium (SiN), matériaux dont la constante diélectrique k est inférieure à 7, SiCO, SiC, SiCN, SiOCN, SiCBN ;
- Masquage du deuxième motif de grille par une couche de masquage (700) ;
- Gravure isotrope de la deuxième couche de protection (600) située sur le premier motif (200) de grille, de manière à retirer entièrement la deuxième couche de protection (600) située sur le premier motif (200) de grille, en conservant la première couche de protection (500) sur le premier motif (200) de grille, le deuxième motif (300) de grille étant masqué par la couche de masquage (700) lors de cette gravure isotrope;
- Retrait de la couche de masquage (700) après l'étape de gravure isotrope ;
- Avant l'étape de masquage ou après l'étape de retrait de la couche de masquage (700): gravure anisotrope de la deuxième couche de protection (600) sélectivement à la première couche de protection (500), de manière à retirer au moins en partie la deuxième couche de protection (600) située sur un sommet (320) du deuxième motif (300) de grille et à conserver au moins une partie de l'épaisseur de la deuxième couche de protection (600) située sur des flancs (310) du deuxième motif (300) de grille,
- avant l'étape de dépôt de la première et de la deuxième couche de protection (500, 600), une étape de dépôt sur les premier et deuxième motifs (200, 300) de grille de la troisième couche de protection (400) disposée sous la première couche de protection (500) et recouvrant les premier et deuxième motifs (200, 300) de grille,
- après la gravure anisotrope de la deuxième couche de protection (600) sélectivement à la première couche de protection (500) : une étape de gravure de la première couche de protection (500) sélectivement à la troisième couche de protection (400) de manière à retirer entièrement sur le premier motif (200) de grille la première couche de protection (500) et à conserver la troisième couche de protection (400).

2. Procédé selon la revendication précédente dans lequel le premier motif (200) de grille est un premier empilement de grille et dans lequel le deuxième motif (300) de grille est un deuxième empilement de grille, chacun des premier et deuxième empilements de grille comprend au moins une couche isolante (201, 301), typiquement un oxyde de grille.

3. Procédé selon la revendication 1 dans lequel le premier motif de grille (200) est un motif sacrificiel, dans lequel le deuxième motif (300) est un motif sacrificiel, le procédé comprenant, après ladite étape de gravure anisotrope de la deuxième couche de protection (600) sélectivement à la première couche de protection (500), une étape de remplacement des premiers et deuxième motifs (200, 300) sacrificiels par des motifs formant respectivement un premier empilement de grille et un deuxième empilement de grille, chacun des premier et deuxième empilements de grille comprend au moins une couche isolante (201, 301), typiquement un oxyde de grille.

4. Procédé selon l'une quelconque des deux revendications précédentes dans lequel l'épaisseur de la couche isolante (301) du deuxième empilement est supérieure à l'épaisseur de la couche isolante (201) du premier empilement.

5. Procédé selon l'une quelconque des revendications précédentes dans lequel la deuxième couche de protection (600) et la troisième couche de protection (400) sont poreuses ou non.

6. Procédé selon l'une quelconque des revendications précédentes dans lequel la troisième couche de protection (400) présente une épaisseur comprise entre 3 et 10 nm (10⁻⁹ mètres) et de préférence entre 4 et 8 nm (10⁻⁹ mètres).

7. Procédé selon l'une quelconque des revendications précédentes dans lequel le dépôt d'au moins l'une parmi la première (500), la deuxième (600) et la troisième (400) couches protection est un dépôt conforme et de préférence, dans lequel chacun des dépôts des première (500), deuxième (600) et troisième (400) couches protection est un dépôt conforme.

8. Procédé selon l'une quelconque des revendications précédentes comprenant, après l'étape de gravure anisotrope de la deuxième couche de protection (600), une étape de retrait de la première couche de protection (500) située sur le sommet (320) du deuxième motif (300) de grille, sur le premier motif (200) de grille et entre les premier et deuxième motif (200, 300) de grille, par gravure sélective du matériau de la première couche de protection (500) vis-à-vis du matériau de la deuxième couche de protection (600) et du matériau de la troisième couche de protection (400).

9. Procédé selon la revendication précédente comprenant, après l'étape de retrait de la première couche (500) sur le premier motif (200) de grille, une étape de dépôt d'une couche d'encapsulation (1000) en un matériau présentant une constante diélectrique inférieure ou égale à 8 sur au moins le deuxième motif (300) de grille.

10. Procédé selon l'une quelconque des revendications précédentes dans lequel la première couche de protection (500) est un oxyde, de préférence de l'oxyde de silicium (SiO2).

11. Procédé selon l'une quelconque des revendications précédentes dans lequel l'étape de gravure isotrope de la deuxième couche de protection (600) est une gravure humide, de préférence à base d'une solution de H3P04.

12. Procédé selon l'une quelconque des revendications 1 à 10 dans lequel l'étape de gravure isotrope de la deuxième couche de protection (600) est une gravure sèche, utilisant de préférence une chimie fluorocarbonée ou fluorée et dans lequel la gravure sèche est de préférence effectuée dans un réacteur plasma dans lequel une tension de polarisation ou la tension de la source est pulsée.

13. Procédé selon l'une quelconque des revendications précédentes dans lequel la deuxième couche de protection (600) est un nitrure ou un matériau présentant une constante diélectrique inférieure à 7 et ladite étape de gravure anisotrope de la deuxième couche de protection (600) comprend :
- une étape de protection par formation d'un film protecteur (900) d'oxyde sur les premier et deuxième motifs (200, 300) de grille ;
- la gravure anisotrope du film protecteur (900) d'oxyde en dehors des flancs (210, 310) des premier et deuxième motifs (200, 300) de grille de manière à conserver le film protecteur (900) d'oxyde uniquement sur les flancs (210, 310) des premier et deuxième motifs (200, 300) de grille ;
- la gravure d'une partie au moins de la deuxième couche de protection (600) située sur un sommet (320) et de part et d'autre du deuxième motif (300) de grille, la gravure étant sélective vis-à-vis du film protecteur (900) d'oxyde situé sur les flancs (210, 310) des premier et deuxième motifs (200, 300) de grille et de la première couche de protection (500) située sur le sommet (220) du premier motif (200) de grille.

14. Procédé selon l'une quelconque des revendications précédentes dans lequel la deuxième couche de protection (600) est en nitrure, de préférence en nitrure de silicium (SiN) ou en un matériau dont la constante diélectrique est inférieure à 7, la première couche de protection (500) est un oxyde, de préférence un oxyde de silicium (SiO2) et le film protecteur (900) d'oxyde est formé à partir d'un plasma à base d'oxygène.

## Patentansprüche

1. Verfahren zur Herstellung auf demselben Substrat (100) vom Typ Silicon-on-Insulator (SOI) oder Fully-Depleted-Silicon-on-Insulator (FDSOI) mindestens eines ersten Transistors und mindestens eines zweiten Transistors, wobei das Verfahren mindestens die folgenden Schritte umfasst:
- Herstellen, auf einem Substrat (100), mindestens eines ersten Gittermotivs (200) und mindestens eines zweiten Gittermotivs (300);
- Ablagern, auf dem ersten und dem zweiten Gittermotiv (200, 300), mindestens:
• einer ersten Schutzschicht (500),
• einer zweiten Schutzschicht (600), die die erste Schutzschicht (500) überlagert und aus einem Material gemacht ist, das sich von dem der ersten Schutzschicht (500) unterscheidet,
• einer dritten Schutzschicht (400), die von der ersten Schutzschicht (500) und von der zweiten Schutzschicht (600) überlagert ist, wobei die dritte Schutzschicht (400) aus einem Material ist, das eine Gravur des Materials der ersten Schutzschicht (500) selektiv zum Material der dritten Schutzschicht (400) erlaubt, und
die zweite Schutzschicht (600) und die dritte Schutzschicht (400) jeweils aus einem Material von den folgenden Materialien gemacht sind: Siliciumnitrid (SiN), Materialien, deren dielektrische Konstante k kleiner als 7 ist, SiCO, SiC, SiCN, SiOCN, SiCBN;
- Maskieren des zweiten Gittermotivs durch eine Maskierungsschicht (700);
- isotropes Gravieren der zweiten Schutzschicht (600), die sich auf dem ersten Gittermotiv (200) befindet, derart, dass die zweite Schutzschicht (600), die sich auf dem ersten Gittermotiv (200) befindet, vollständig entfernt wird, bei Beibehaltung der ersten Schutzschicht (500) auf dem ersten Gittermotiv (200), wobei bei dieser isotropen Gravur das zweite Gittermotiv (300) von der Maskierungsschicht (700) maskiert wird;
- Entfernen der Maskierungsschicht (700) nach dem Schritt der isotropen Gravur;
- vor dem Maskierungsschritt oder nach dem Schritt des Entfernens der Maskierungsschicht (700): anisotrope Gravur der zweiten Schutzschicht (600) selektiv zu der ersten Schutzschicht (500) derart, dass die zweite Schutzschicht (600) mindestens teilweise entfernt wird, die sich auf einer Spitze (320) des zweiten Gittermotivs (300) befindet, und mindestens ein Teil der Dicke der zweiten Schutzschicht (600) beibehalten wird, die sich auf den Flanken (310) des zweiten Gittermotivs (300) befindet,
- vor dem Schritt des Ablagerns der ersten und der zweiten Schutzschicht (500, 600), einen Schritt des Ablagerns auf dem ersten und zweiten Gittermotiv (200, 300) der dritten Schutzschicht (400), die unter der ersten Schutzschicht (500) angeordnet ist und das erste und zweite Gittermotiv (200, 300) bedeckt,
- nach der anisotropen Gravur der zweiten Schutzschicht (600) selektiv zu der ersten Schutzschicht (500): einen Gravurschritt der ersten Schutzschicht (500) selektiv zu der dritten Schutzschicht (400), so dass die erste Schutzschicht (500) auf dem ersten Gittermotiv (200) vorzugweise vollständig entfernt und die dritte Schutzschicht (400) beibehalten wird.

2. Verfahren nach vorangehendem Anspruch, wobei das erste Gittermotiv (200) ein erster Gitterstapel ist und wobei das zweite Gittermotiv (300) ein zweiter Gitterstapel ist, wobei jeder von dem ersten und zweiten Gitterstapel mindestens eine Isolierschicht (201, 301), in typischer Weise ein Gitteroxid, umfasst.

3. Verfahren nach Anspruch 1, wobei das erste Gittermotiv (200) ein Opfermotiv ist, wobei das zweite Motiv (300) ein Opfermotiv ist, wobei das Verfahren nach dem anisotropen Gravurschritt der zweiten Schutzschicht (600) selektiv zu der ersten Schutzschicht (500) einen Schritt des Ersetzens des ersten und zweiten Opfermotivs (200, 300) durch Motive ist, die jeweils einen ersten Gitterstapel und einen zweiten Gitterstapel bilden, wobei jeder von dem ersten und zweiten Gitterstapel mindestens eine Isolierschicht (201, 301), in typischer Weise ein Gitteroxid, umfasst.

4. Verfahren nach einem der zwei vorangehenden Ansprüche, wobei die Dicke der Isolierschicht (301) des zweiten Stapels größer als die Dicke der Isolierschicht (201) des ersten Stapels ist.

5. Verfahren nach einem der vorangehenden Ansprüche, wobei die zweite Schutzschicht (600) und die dritte Schutzschicht (400) porös sind oder nicht.

6. Verfahren nach einem der vorangehenden Ansprüche, wobei die dritte Schutzschicht (400) eine Dicke aufweist, die zwischen 3 und 10 nm (10⁻⁹ Meter) und vorzugsweise zwischen 4 und 8 nm (10⁻⁹ Meter) liegt.

7. Verfahren nach einem der vorangehenden Ansprüche, wobei die Ablagerung von mindestens einer von der ersten (500), der zweiten (600) und der dritten (400) Schutzschicht eine konforme Ablagerung ist und wobei vorzugsweise jede der Ablagerungen der ersten (500), zweiten (600) und dritten (400) Schutzschicht eine konforme Ablagerung ist.

8. Verfahren nach einem der vorangehenden Ansprüche, umfassend, nach dem anisotropen Gravurschritt der zweiten Schutzschicht (600), einen Schritt des Entfernens der ersten Schutzschicht (500), die sich auf der Spitze (320) des zweiten Gittermotivs (300), auf dem ersten Gittermotiv (200) und zwischen dem ersten und zweiten Gittermotiv (200, 300) befindet, durch selektive Gravur des Materials der ersten Schutzschicht (500) gegenüber dem Material der zweiten Schutzschicht (600) und dem Material der dritten Schutzschicht (400).

9. Verfahren nach vorangehendem Anspruch, umfassend, nach dem Schritt des Entfernens der ersten Schicht (500) auf dem ersten Gittermotiv (200), einen Schritt des Ablagerns einer Kapselschicht (1000) aus einem Material, das eine dielektrische Konstante kleiner oder gleich 8 aufweist, auf mindestens dem zweiten Gittermotiv (300).

10. Verfahren nach einem der vorangehenden Ansprüche, wobei die erste Schutzschicht (500) ein Oxid ist, vorzugsweise Siliciumoxid (SiO₂).

11. Verfahren nach einem der vorangehenden Ansprüche, wobei der isotrope Gravurschritt der zweiten Schutzschicht (600) eine feuchte Gravur ist, vorzugsweise auf der Basis einer H₃PO₄-Lösung.

12. Verfahren nach einem der Ansprüche 1 bis 10, wobei der isotrope Gravurschritt der zweiten Schutzschicht (600) eine trockene Gravur ist, die vorzugsweise Fluorcarbon- oder Fluorchemie verwendet, und wobei die trockene Gravur vorzugsweise in einem Plasmareaktor durchgeführt wird, in dem eine Polarisationsspannung oder die Quellspannung gepulst wird.

13. Verfahren nach einem der vorangehenden Ansprüche, wobei die zweite Schutzschicht (600) ein Nitrid oder ein Material ist, das eine dielektrische Konstante unter 7 aufweist und der anisotrope Gravurschritt der zweiten Schutzschicht (600) umfasst:
- einen Schritt des Schützens durch Bilden eines Oxidschutzfilms (900) auf dem ersten und zweiten Gittermotiv (200, 300);
- das anisotrope Gravieren des Oxidschutzfilms (900) außerhalb der Flanken (210, 310) des ersten und zweiten Gittermotivs (200, 300) derart, dass der Oxidschutzfilm (900) nur auf den Flanken (210, 310) des ersten und zweiten Gittermotivs (200, 300) beibehalten wird;
- das Gravieren mindestens eines Teils der zweiten Schutzschicht (600), die sich auf einer Spitze (320) und beiderseits des zweiten Gittermotivs (300) befindet, wobei die Gravur selektiv gegenüber dem Oxidschutzfilm (900) ist, der sich auf den Flanken (210, 310) des ersten und zweiten Gittermotivs (200, 300) und der ersten Schutzschicht (500) befindet, die sich auf der Spitze (220) des ersten Gittermotivs (200) befindet.

14. Verfahren nach einem der vorangehenden Ansprüche, wobei die zweite Schutzschicht (600) aus Nitrid, vorzugsweise aus Siliciumnitrid (SiN) oder aus einem Material ist, dessen dielektrische Konstante kleiner als 7 ist, die erste Schutzschicht (500) ein Oxid ist, vorzugsweise ein Siliciumoxid (SiO₂), und der Schutzfilm (900) aus einem Plasma auf der Basis von Sauerstoff gebildet ist.

## Claims

1. Method for forming, on a single substrate (100) of the semiconductor on insulator (SOI) type or fully depleted semiconductor on insulator (FDSOI) type, at least one first transistor and at least one second transistor, the method comprising at least the following steps of:
- Forming, on a substrate (100), at least one first gate pattern (200) and at least one second gate pattern (300);
- Depositing, on the first and second gate patterns (200, 300) at least:
• a first protective layer (500),
• a second protective layer (600) overlaying the first protective layer (500) and made of a material that is different from that of the first protective layer (500),
• a third protective layer (400) overlaid by the first protective layer (500) and by the second protective layer (600), the third protective layer (400) being made of a material that allows the material of the first protective layer (500) to be selectively etched relative to the material of the third protective layer (400); and
the second protective layer (600) and the third protective layer (400) are each made of a material selected from among the following materials: silicon nitride (SiN), materials whose dielectric constant k is less than 7, SiCO, SiC, SiCN, SiOCN, SiCBN;
- Masking the second gate pattern by a masking layer (700);
- Isotropic etching of the second protective layer (600) located on the first gate pattern (200), so as to completely remove the second protective layer (600) located on the first gate pattern (200), while preserving the first protective layer (500) on the first gate pattern (200), the second gate pattern (300) being masked by the masking layer (700) during this isotropic etching;
- Removing the masking layer (700) after the isotropic etching step;
- Before the masking step or after the step of removing the masking layer (700): selective anisotropic etching of the second protective layer (600) relative to the first protective layer (500), so as to at least partially remove the second protective layer (600) located on a top (320) of the second gate pattern (300) and so as to preserve at least a part of the thickness of the second protective layer (600) located on the sidewalls (310) of the second gate pattern (300);
- Before the step of depositing the first and the second protective layers (500, 600), a step of depositing, on the first and second gate patterns (200, 300), the third protective layer (400) disposed beneath the first protective layer (500) and covering the first and second gate patterns (200, 300);
- After the selective anisotropic etching of the second protective layer (600) relative to the first protective layer (500): a step of selectively etching the first protective layer (500) relative to the third protective layer (400) so as to completely remove the first protective layer (500) from the first gate pattern (200) and so as to preserve the third protective layer (400).

2. Method according to the preceding claim, wherein the first gate pattern (200) is a first gate stack and wherein the second gate pattern (300) is a second gate stack, each of the first and second gate stacks comprising at least one insulating layer (201, 301), typically a gate oxide.

3. Method according to claim 1, wherein the first gate pattern (200) is a sacrificial pattern, wherein the second pattern (300) is a sacrificial pattern, the method comprising, after said step of selective anisotropic etching of the second protective layer (600) relative to the first protective layer (500), a step of replacing the first and second sacrificial patterns (200, 300) with patterns respectively forming a first gate stack and a second gate stack, each of the first and second gate stacks comprising at least one insulating layer (201, 301), typically a gate oxide.

4. Method according to any of the preceding two claims, wherein the thickness of the insulating layer (301) of the second stack is greater than the thickness of the insulating layer (201) of the first stack.

5. Method according to any of the preceding claims, wherein the second protective layer (600) and the third protective layer (400) are porous or non-porous.

6. Method according to any of the preceding claims, wherein the thickness of the third protective layer (400) lies in the range 3 to 10 nm (10⁻⁹ metres) and preferably in the range 4 to 8 nm (10⁻⁹ metres).

7. Method according to any of the preceding claims, wherein the deposition of at least one from among the first (500), the second (600) and the third (400) protective layers is a conformal deposition, and preferably wherein each of the depositions of the first (500), second (600) and third (400) protective layers is a conformal deposition.

8. Method according to any of the preceding claims, comprising, after the step of anisotropic etching of the second protective layer (600), a step of removing the first protective layer (500) located on the top (320) of the second gate pattern (300), on the first gate pattern (200) and between the first and second gate patterns (200, 300), by selective etching of the material of the first protective layer (500) relative to the material of the second protective layer (600) and to the material of the third protective layer (400).

9. Method according to the preceding claim, comprising, after the step of removing the first layer (500) from the first gate pattern (200), a step of depositing an encapsulating layer (1000) made of a material having a dielectric constant of less than or equal to 8 on at least the second gate pattern (300).

10. Method according to any of the preceding claims, wherein the first protective layer (500) is an oxide, preferably silicon oxide (SiO2).

11. Method according to any of the preceding claims, wherein the step of isotropic etching of the second protective layer (600) is a wet etching, preferably based on a H₃PO₄ solution.

12. Method according to any of claims 1 to 10, wherein the step of isotropic etching of the second protective layer (600) is a dry etching, preferably using a fluorocarbon or fluorinated chemical, and wherein the dry etching is preferably carried out in a plasma reactor wherein a bias voltage or the voltage of the source is pulsed.

13. Method according to any of the preceding claims, wherein the second protective layer (600) is a nitride or a material having a dielectric constant of less than 7 and said step of anisotropic etching of the second protective layer (600) comprises:
- a protection step by forming an oxide protecting film (900) on the first and second gate patterns (200, 300);
- the anisotropic etching of the oxide protecting film (900) outside of the sidewalls (210, 310) of the first and second gate patterns (200, 300) so as to preserve the oxide protecting film (900) only on the sidewalls (210, 310) of the first and second gate patterns (200, 300);
- the etching of at least part of the second protective layer (600) located on a top (320) and on either side of the second gate pattern (300), the etching being selective relative to the oxide protecting film (900) located on the sidewalls (210, 310) of the first and second gate patterns (200, 300) and to the first protective layer (500) located on the top (220) of the first gate pattern (200).

14. Method according to any of the preceding claims, wherein the second protective layer (600) is made of nitride, preferably silicon nitride (SiN) or is made of a material whose dielectric constant is less than 7, the first protective layer (500) is an oxide, preferably a silicon oxide (SiO2) and the oxide protecting film (900) is formed from an oxygen-based plasma.
